(19) Europäisches Patentamt
European Patent Office
Office européen des brevets

(11) Veröffentlichungsnummer: **0 212 440**
**B1**

(12) # EUROPÄISCHE PATENTSCHRIFT

(45) Veröffentlichungstag der Patentschrift: **13.06.90**

(51) Int. Cl.⁵: **G03F 7/038**, G03F 7/004, G03F 7/039

(21) Anmeldenummer: **86110846.2**

(22) Anmeldetag: **05.08.86**

(54) **Strahlungsempfindliches Gemisch, dieses enthaltendes strahlungsempfindliches Aufzeichnungsmaterial und Verfahren zur Herstellung von Reliefbildern.**

(30) Priorität: **13.08.85 DE 3528929**

(43) Veröffentlichungstag der Anmeldung:
**04.03.87 Patentblatt 87/10**

(45) Bekanntmachung des Hinweises auf die Patenterteilung:
**13.06.90 Patentblatt 90/24**

(84) Benannte Vertragsstaaten:
**AT BE CH DE FR GB IT LI NL SE**

(56) Entgegenhaltungen:
**EP-A- 0 184 044**
**EP-A- 0 191 400**
**DE-A- 3 309 222**
**DE-A- 3 329 443**
**FR-A- 2 336 707**
**GB-A- 1 119 667**
**US-A- 4 025 710**

(73) Patentinhaber: **HOECHST AKTIENGESELLSCHAFT, Postfach 80 03 20, D-6230 Frankfurt am Main 80(DE)**

(72) Erfinder: **Schneller, Arnold, Dr., Dipl.-Chem., Asternweg 41, D-6500 Mainz 21(DE)**
Erfinder: **Schulze, Ralf, Dr., Dipl.-Chem., Völklinger Weg 66, D-6000 Frankfurt 71(DE)**
Erfinder: **Sander, Jürgen, Dr., Dipl.-Chem., Eichkopfallee 27, D-6237 Liederbach(DE)**
Erfinder: **Erbes, Kurt, Friedrich-Stolz-Strasse 3, D-6013 Flörsheim(DE)**

EP 0 212 440 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

## Beschreibung

Die Erfindung betrifft strahlungsempfindliche Gemische, die insbesondere für die Herstellung von Photoresistschablonen und Druckplatten geeignet sind.

Erfindungsgemäß werden insbesondere positiv arbeitende strahlungs- bzw. lichtempfindliche Gemische auf Basis von Kombinationen photolytisch aktivierbarer Säurespender mit säurespaltbaren Verbindungen und wasserunlöslichen, in wäßrig-alkalischen Lösungen löslichen Bindemitteln vorgeschlagen.

Positiv arbeitende lichtempfindliche Gemische, d. h. Gemische, deren Kopierschicht an den belichteten Stellen löslich wird, aus den genannten Bestandteilen sind bekannt.

Diese Gemische enthalten als alkalilösliche Bindemittel in der überwiegenden Mehrzahl Phenol-Formaldehyd-Kondensationsprodukte, insbesondere Novolake. Als weitere mögliche alkalilösliche Bindemittel werden Copolymerisate von Maleinsäureanhydrid und Styrol, von Vinylacetat und Crotonsäure, von Alkylmethacrylat, Butadien und Methacrylsäure (DE-A 31 07 526) sowie Polymerisate des Vinylphenols (DE-A 33 09 222) beschrieben. Diese Polymerisate werden offensichtlich nicht bevorzugt. Praktisch alle bekannten Handelsprodukte enthalten deshalb Novolake. Die Novolake als Bindemittel haben für bestimmte Anwendungszwecke Nachteile.

Für einen Einsatz als Bindemittel in Trockenresistschichten sind Novolake aufgrund ihres niedrigen Molekulargewichts zu spröde, so daß es bei der Verarbeitung oft zu Brüchen der Schicht kommt, z. B. beim Belichten im Kontakt mit einer Maske oder beim Laminieren als Trockenresist auf eine Trägeroberfläche. Diese Eigenschaft, die sich besonders stark bei den für Trockenresistmaterialien bevorzugten größeren Schichtdicken auswirkt, wird durch mehrere Faktoren hervorgerufen:

Zum einen wird durch den Einbau von aromatischen Gruppen in die Hauptkette diese sehr stark in ihrer Beweglichkeit eingeschränkt, was sich in einer hohen Glastemperatur und geringen Flexibilität äußert. Zum zweiten führt die üblicherweise für die Synthese von Novolaken angewandte Kondensation von Phenolen oder Kresolen mit Formaldehyd unter sauren Bedingungen aufgrund der Polyfunktionalität der eingesetzten Verbindungen lediglich zu Produkten mit geringem Molekulargewicht oder hohem Verzweigungs- bzw. Vernetzungsgrad.

Als Folge dieser novolakspezifischen Nachteile ist das Filmbildungsvermögen und die Flexibilität solcher Verbindungen zu gering, um damit in Kombination mit lichtempfindlichen Systemen Trockenresistfilme herstellen zu können, die sich einwandfrei von der Rolle verarbeiten lassen, ohne daß es zu Brüchen der Schicht oder Umspringen des Resists von der Träger- auf die Deckfolie kommt.

Die Sprödigkeit des Novolaks ist auch der Grund für Verarbeitungsprobleme beim Einsatz dieser Bindemittel in der Mikroelektronik. Beim Belichten im innigen Kontakt mit einer Maske kann es leicht zu Brüchen oder Ausrissen der Schicht kommen.

In der EP-A 0 042 562 wird ein entsprechendes lichtempfindliches Gemisch beschrieben, das zur Erhöhung der Flexibilität der Schicht und zur Verbesserung anderer Eigenschaften zusätzlich zu dem alkalilöslichen Novolak ein weiteres Polymeres enthält, z. B. ein Polyurethan, einen Polyvinylalkylether, ein Polyalkylacrylat oder ein hydriertes Kolophoniumderivat. Durch den Zusatz dieser Harze, die ein anderes Löslichkeitsverhalten als Novolake haben, werden aber wieder andere Eigenschaften, wie Entwickelbarkeit, Säure- oder Alkaliresistenz der Bildschablone, beeinträchtigt.

Es wurden daher verschiedene Vorschläge gemacht, den Novolak in positiv arbeitenden Schichten durch andere alkalilösliche Bindemittel zu ersetzen.

Polyvinylphenol wird in der DE-C 23 22 230 als Novolakersatz in Schichten mit o-Chinondiaziden vorgeschlagen. Obwohl die Plasmaresistenz und die Haftung auf Siliciumoberflächen grundsätzlich mit Novolaken vergleichbar sind, werden unbelichtete Photoresistschichten mit diesem Polymeren beim Entwickeln zu stark abgetragen. Mit zunehmendem Molekulargewicht nimmt der Abtrag zwar ab, liegt aber in den besten Fällen (MG ≅ 25.000) immer noch etwa um den Faktor 100 höher als bei Schichten mit Novolaken (nach T.R. Pampalone, Solid State Technology, Juni 1984, S. 119). Nachteilig ist weiterhin die präparativ aufwendige Synthese und die geringe Polymerisationsneigung des monomeren Vinylphenols.

In der JP-A 51/36 129 werden Polymere auf Basis von Hydrochinon- und Dihydroxynaphthalinmonomethacrylat als Bindemittel für Naphthochinondiazidschichten beschrieben.

Alle diese Gemische mit o-Chinondiaziden als lichtempfindliche Verbindungen haben gegenüber den Gemischen mit den eingangs erwähnten säurespaltbaren Verbindungen den Nachteil einer deutlich geringeren Lichtempfindlichkeit. Dies wirkt sich vor allem bei Anwendungen aus, bei denen höhere Schichtdicken erforderlich sind, z. B. beim Trockenresistverfahren.

Es war daher Aufgabe der Erfindung, positiv arbeitende Gemische der eingangs beschriebenen Gattung bereitzustellen, die sich mit wäßrig-alkalischen Lösungen entwickeln lassen und die lichtempfindliche Schichten mit einer gegenüber den bekannten Gemischen erhöhten Lichtempfindlichkeit und Flexibilität sowie guter Resistenz gegen Entwickler und andere Verarbeitungsmedien bilden.

Gegenstand der Erfindung ist ein strahlungsempfindliches Gemisch, das als wesentliche Bestandteile

A) ein in Wasser unlösliches, in wäßrig-alkalischen Lösungen lösliches polymeres Bindemittel mit seitenständigen phenolischen Hydroxygruppen und

B)1) eine Kombination aus

a) einer unter Einwirkung von aktinischer Strahlung eine starke Säure bildenden Verbindung und

b) einer Verbindung mit mindestens einer durch Säure spaltbaren C-O-C-Bindung enthält, deren Löslichkeit in einem flüssigen Entwickler durch Einwirkung von Säure erhöht wird.

Das erfindungsgemäße Gemisch ist dadurch gekennzeichnet, daß das Bindemittel ein Polymeres mit wiederkehrenden Einheiten der allgemeinen Formel I

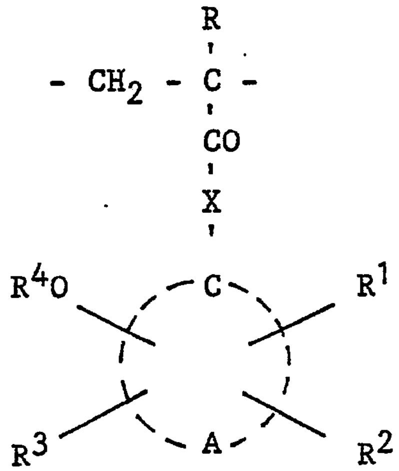

(I)

ist, worin
R ein Wasserstoff- oder Halogenatom, eine Cyanidgruppe oder eine Alkylgruppe mit 1-4 Kohlenstoffatomen ist,
$R^1$, $R^2$ und $R^3$ gleich oder verschieden sind und Wasserstoff- oder Halogenatome, Alkyl-, Alkoxy-, Alkoxycarbonyl-, Acyl-, Aryloxy-, Aroyl- oder Aralkylgruppen bedeuten,
$R^4$ ein Wasserstoffatom oder eine zweiwertige organische Gruppe ist, die mit einer weiteren Einheit der Formel I inter- oder intramolekular verknüpft ist, wobei im Mittel in mindestens 80 mol-% der Einheiten der Formel I $R^4$ ein Wasserstoffatom ist,
X ein Sauerstoffatom oder eine der Gruppen $NR^8$, $OCH_2CHOHCH_2OCO$, $OCH_2CH_2O$ und $OCH_2CH_2OCO$ ist, worin $R^8$ ein Wasserstoffatom, eine Alkyl- oder Arylgruppe bedeutet, und
A die zur Vervollständigung eines ein- oder zweikernigen carbo- oder heterocyclischen aromatischen Ringsystems erforderlichen Atome bedeutet.

Das erfindungsgemäße Polymere kann ein Homopolymeres oder ein Copolymeres sein, das neben Einheiten der Formel I andere von copolymerisierbaren ethylenisch ungesättigten Monomeren abgeleitete Einheiten enthält. Die Comonomeren sind im allgemeinen Monovinylverbindungen. Sie können auch vernetzungsfähige Gruppen enthalten, die sich katalytisch oder thermisch vernetzen lassen. Die Vernetzung kann zur Härtung der Bildschablone nach dem Entwickeln, vorzugsweise durch Erhitzen, vorgenommen werden.

Wenn in der Formel I R eine Alkylgruppe ist, enthält diese im allgemeinen 1 bis 6, bevorzugt 1 oder 2 Kohlenstoffatome. Besonders bevorzugt werden Verbindungen mit R = H oder Methyl.

Von den Substituenten $R^1$, $R^2$ und $R^3$ ist bevorzugt mindestens einer ein Wasserstoffatom, besonders bevorzugt sind mindestens zwei davon Wasserstoffatome. Wenn diese Symbole Alkyl- oder Alkoxygruppen bedeuten, haben diese bevorzugt 1 bis 6, insbesondere 1 bis 3 Kohlenstoffatome.

Allgemein sind hier unter Alkylgruppen verzweigte und unverzweigte, gesättigte und ungesättigte Gruppen mit cyclischen und offenen Ketten zu verstehen, die durch Halogenatome oder Hydroxygruppen substituiert sein oder Ether- oder Ketogruppen enthalten können. Bevorzugt werden unverzweigte, insbesondere gesättigte Kohlenwasserstoffreste mit 1 bis 3 Kohlenstoffatomen.

Wenn das aromatische Ringsystem A heterocyclisch ist, kann es z. B. ein Pyridin-, Pyrimidin-, Pyrazin-, Chinolin-, Isochinolin-, Chinoxalin-, Indol- oder Thiophensystem sein. Als aromatische Ringsysteme kommen Benzol, Naphthalin und Biphenyl in Betracht; besonders bevorzugt wird ein Benzolring.

Die Stellung der Gruppe $OR^4$ unterliegt keinerlei Beschränkungen; sie richtet sich nach der präparativen Zugänglichkeit.

Die Stellung der Reste $R^1$, $R^2$ und $R^3$ richtet sich nach der Stellung der Gruppe $OR^4$.

Wenn $R^4$ eine zweiwertige Gruppe ist, liegt diese im Polymeren in solchem Mengenanteil vor, daß die Löslichkeit des Produkts nicht beeinträchtigt wird. Im allgemeinen enthalten nicht mehr als 20 mol-%, vorzugsweise nicht mehr als 10 mol-% der Einheiten der Formel I eine Gruppe $R^4O$, in der $R^4$ von H verschieden ist. $R^4$ kann in diesem Falle eine aromatische oder aliphatische Gruppe sein, die vorzugsweise 2 bis 15 Kohlenstoffatome enthält und z. B. durch Umsetzen eines Diepoxids oder Diisocyanats mit OH-Gruppen entstanden ist. Dabei werden als Reaktionspartner Diisocyanate bevorzugt. Beispiele für geeignete Diisocyanate sind Tolylen-, Hexamethylen-, 2,2,4-Trimethylhexamethylen-, Lysin-, Isophoron- und Diphenylmethandiisocyanat.

Beispiele für erfindungsgemäß geeignete Einheiten der Formel I sind solche aus Monoacrylaten oder -methacrylaten des Hydrochinons, Brenzcatechins, Resorcins, des Methyl- oder Chlorresorcins, Ethylhydrochinons, 2,3-Dihydroxy-naphthalins, 4,4'-Dihydroxy-biphenyls, 2,2-Bis-(4-hydroxyphenyl)-propans, 5,8-Dihydroxychinolins, des Salicylsäure-β-hydroxyethylesters, 2-Hydroxy-3-naphthoesäure-β-hydroxyethylesters, des 4-Chlor- oder 4-Brom-salicylsäure-2,3-dihydroxypropylesters, des 4,4'-Dihydroxy-benzophenons oder des 2,4-Dihydroxy-acetophenons. Weitere Beispiele sind Einheiten aus (Meth)acrylsäureamiden des o-, m- oder p-Aminophenols oder des 1-Amino-naphthols-(7).

Monomere des der Formel I entsprechenden Typs lassen sich beispielsweise herstellen durch Umsetzung von gegebenenfalls substituierten Hydroxybenzoesäuren mit Hydroxyalkylacrylat bzw. -methacrylat, mit Glycidylacrylat oder -methacrylat oder durch Veresterung oder Amidierung von Acryl- oder Methacrylsäure mit den entsprechenden substituierten Phenolen.

Die Homopolymerisation dieser Monomeren oder deren Copolymerisation mit anderen Monomeren läßt sich nach konventionellen Methoden durchführen, beispielsweise in Gegenwart eines Polymerisationsinitiators wie Azo-bis-isobuttersäurenitril in organischen Lösungsmitteln wie Butanon oder Ethanol bei erhöhten Temperaturen innerhalb von 1 bis 20 Stunden. Daneben ist aber auch eine Suspensions-, Emulsions- oder Massepolymerisation möglich, die auch durch Strahlung, Hitze oder ionische Initiatoren ausgelöst werden kann.

Die Polymeren mit Einheiten der Formel I können Homopolymerisate, welche ausschließlich Struktureinheiten der Formel I enthalten, oder Mischpolymerisate aus Monomeren entsprechend der Formel I und einem oder mehreren anderen Vinylmonomeren, gegebenenfalls auch solchen mit phenolischen Gruppen, sein.

Weiterhin können verschiedene Monomere entsprechend Formel I miteinander, gegebenenfalls auch mit weiteren Vinylmonomeren, copolymerisiert werden.

Das Molekulargewicht der Homo- bzw. Copolymeren kann in weiten Grenzen variiert werden; bevorzugt werden Polymerisate mit $\overline{M}_n$ = 1000 - 200.000, besonders solche mit $\overline{M}_n$ = 5000 - 100.000. Die Hydroxylzahl liegt im allgemeinen im Bereich von 100 bis etwa 450, vorzugsweise zwischen 200 und 350.

Die Auswahl von geeigneten Homo- und Copolymeren richtet sich im Einzelfall nach dem Anwendungszweck und nach der Art der übrigen Komponenten in dem strahlungs- bzw. lichtempfindlichen Gemisch. So ist die Hydrophilie des Bindemittels eines lichtempfindlichen Gemischs von Bedeutung für die Lichtempfindlichkeit, Entwicklungszeit und Entwicklerresistenz. Die Hydrophilie muß daher an das jeweilige lichtempfindliche System angepaßt werden.

Wichtig für die anwendungstechnischen Eigenschaften eines lichtempfindlichen Gemischs ist weiterhin seine Erweichungstemperatur, die wesentlich durch die des Bindemittels bestimmt wird. Sie läßt sich durch Wahl der Substituenten am Aromaten und vor allem durch die Wahl der Comonomeren beeinflussen.

Als Comonomere für die Verbindungen, die zu Einheiten der Formel I polymerisieren, werden Verbindungen der allgemeinen Formel

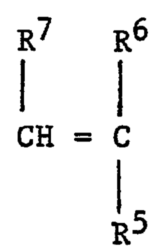

bevorzugt, worin

$R^5$ ein Wasserstoff- oder Halogenatom oder eine Alkylgruppe,

$R^6$ eine Alkyl-, Alkoxy-, Alkoxycarbonyl-, Acyl-, Acyloxy-, Aryl-, Formyl-, Cyanid-, Carboxyl-, Hydroxy- oder Aminocarbonylgruppe und

$R^7$ ein Wasserstoffatom oder eine Carboxylgruppe ist, die mit $R^6$, wenn dieses eine Carboxylgruppe ist, zu einem Säureanhydrid verbunden sein kann.

Wenn $R^5$ oder $R^6$ Alkylgruppen sind, haben diese im allgemeinen 1 - 4 Kohlenstoffatome; als Vertreter für $R^6$ kommen in Betracht: Alkoxygruppen mit 1 - 8 C-Atomen, Alkyloxycarbonylgruppen mit 2 - 13 C-Atomen, Acylgruppen mit 2 - 20 C-Atomen, Acyloxygruppen mit 2 - 18 C-Atomen und Arylgruppen mit 6 - 10 C-Atomen. Die Aminocarbonylgruppen können unsubstituiert oder durch eine oder zwei Alkylgruppen mit 1 - 8 C-Atomen substituiert sein. Die Alkylgruppen haben die oben angegebene Bedeutung.

Beispiele für solche Verbindungen sind Styrol, α-Chlorstyrol, α-Methylstyrol, 2-, 3- oder 4-Chlormethyl-styrol, 4-Brom-styrol, Methylvinylether, Ethylvinylether, Propylvinylether, Butylvinylether, Acrylnitril, Acrolein, Butadien, Acrylsäure, Methacrylsäure, die Methyl-, Ethyl-, Propyl-, Butyl-, Pentyl-, Hexyl-, Decyl-, Dodecyl-, 2-Ethylhexyl-, Phenyl-, Benzyl-, Biphenylyl- und Naphthylester dieser Säuren, Methacrylamid, Acrylamid, Vinylacetat, Vinylisobutylketon und Maleinsäureanhydrid.

Der Gehalt an Einheiten der Formel I im Copolymeren richtet sich nach den übrigen Komponenten des

Gemischs und nach der Anwendung. Im allgemeinen werden im erfindungsgemäßen Gemisch Polymere mit einem Gehalt von 20 bis 100 mol-%, vorzugsweise 40 bis 100 mol-% an Einheiten der Formel I eingesetzt.

Zur Herstellung der erfindungsgemäßen Gemische wird das beschriebene Bindemittel zusammen mit strahlungsempfindlichen Kombinationen von photolytischen Säurespendern mit säurespaltbaren Verbindungen eingesetzt, deren Löslichkeit in einer wäßrig-alkalischen Entwicklerlösung beim Belichten oder unter Einwirkung energiereicher Strahlung erhöht wird.

Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal- und/oder Ketalgruppierungen in der Hauptkette und

c) Verbindungen mit mindestens einer Enolether- oder N-Acyliminocarbonatgruppierung.

Durch Säure spaltbare Verbindungen des Typs a) als Komponenten strahlungsempfindlicher Gemische sind in der EP-A 0 022 571 ausführlich beschrieben; Gemische, die Verbindungen des Typs b) enthalten, sind in der DE-C 23 06 248 und der DE-C 27 18 254 beschrieben; Verbindungen des Typs c) werden in den EP-A 0 006 626 und 0 006 627 beschrieben.

Die Art und die Menge des Bindemittels und der spaltbaren Verbindung kann je nach Anwendungsart verschieden sein; bevorzugt werden Anteile des Bindemittels zwischen 30 und 90 Gew.-%, besonders bevorzugt 55 bis 85 Gew.-%. Der Anteil der spaltbaren Verbindung kann variiert werden zwischen 5 und 70 Gew.-%, bevorzugt werden 5 bis 40 Gew.-%. Zusätzlich können noch zahlreiche andere Oligomere und Polymere mitverwendet werden, z. B. Phenolharze vom Novolaktyp oder Vinylpolymerisate wie Polyvinylphenole, Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen und dem Einfluß auf die Entwicklungsbedingungen und beträgt im allgemeinen nicht mehr als 30 % vom Polymerisat mit Einheiten der Formel I. In geringen Mengen kann die lichtempfindliche Schicht für spezielle Erfordernisse wie Flexibilität, Haftung, Glanz etc. außerdem noch Substanzen wie Polyglykole, Celluloseether, z. B. Ethylcellulose, Netzmittel, Verlaufmittel, Farbstoffe und feinteilige Pigmente enthalten.

Als strahlungsempfindliche Komponenten, die beim Bestrahlen vorzugsweise starke Säuren bilden bzw. abspalten, sind eine große Anzahl von bekannten Verbindungen und Mischungen, wie Diazonium-, Phosphonium-, Sulfonium- und Jodonium-Salze, Halogen-Verbindungen, o-Chinondiazidsulfochloride und Organometall-Organohalogen-Kombinationen geeignet.

Die genannten Diazonium-, Phosphonium-, Sulfonium- und Jodonium-Verbindungen werden in der Regel eingesetzt in Form ihrer in organischen Lösungsmitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mehr als einem Halogenatom an einem Kohlenstoffatom oder an einem aromatischen Ring, brauchbar. Beispiele sind in den US-A 3 515 552, 3 536 489 und 3 779 778, der DE-C 26 10 842 und den DE-A 22 43 621, 27 18 259 und 33 37 024 beschrieben. Von diesen Verbindungen werden die s-Triazinderivate mit 2 Halogenmethylgruppen, insbesondere Trichlormethylgruppen, und einem aromatischen bzw. ungesättigten Substituenten im Triazinkern, wie sie in den DE-A 27 18 259 und 33 37 024 beschrieben sind, bevorzugt. Die Wirkung dieser halogenhaltigen Verbindungen kann auch durch bekannte Sensibilisatoren spektral beeinflußt und gesteigert werden.

Beispiele für geeignete Starter sind: 4-(Di-n-propylamino)-benzoldiazoniumtetrafluoroborat, 4-p-Tolylmercapto-2,5-diethoxy-benzoldiazoniumhexafluorophosphat und -tetrafluoroborat, Diphenylamin-4-diazoniumsulfat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlor-propenyl)-2-pyron, 2-Trichlormethylbenzimidazol, 2-Tribrommethyl-chinolin, 2,4-Dimethyl-1-tribromacetyl-benzol, 3-Nitro-1-tribromacetyl-benzol, 4-Dibromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(Naphth-2-yl)-, 2-(4-Ethoxyethyl-naphth-1-yl)-, 2-(Benzopyran-3-yl)-, 2-(4-Methoxyanthrac-1-yl)-, 2-(4-Styryl-phenyl)-, 2-(Phenanthr-9-yl)-4,6-bis-trichlormethyl-s-triazin und die in den Beispielen angeführten Verbindungen.

Die Menge des Starters kann je nach seiner chemischen Natur und der Zusammensetzung des Gemischs ebenfalls sehr verschieden sein. Günstige Ergebnisse werden erhalten mit etwa 0,1 bis 10 Gew.-%, bezogen auf den Gesamtfeststoff, bevorzugt sind 0,2 bis 5 %. Besonders für Kopierschichten von Dicken über 10 µm empfiehlt es sich, relativ wenig Säurespender zu verwenden.

Schließlich können dem lichtempfindlichen Gemisch noch lösliche oder auch feinteilige dispergierbare Farbstoffe sowie je nach Anwendungszweck auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Als Schichtträger für die lichtempfindlichen Gemische eignen sich alle üblicherweise in der Technik in Kopierprozessen eingesetzten Materialien. Als Beispiele seien Kunststoffolien, Isolierplatten mit Kupferauflage, mechanisch oder elektrochemisch aufgerauhtes und ggf. anodisiertes Aluminium, Siebdruckschablonenträger, Holz, Keramik, Glas und Silicium, dessen Oberfläche chemisch, z. B. in Siliciumnitrid oder Siliciumdioxid, umgewandelt sein kann, genannt.

Bevorzugte Träger für dicke Schichten über 10 µm sind Kunststoffolien, die dann als temporäre Träger für Transferschichten dienen. Dafür und für Farbfolien werden Polyesterfolien, z. B. aus Polyethylenterephthalat, bevorzugt. Polyolefinfolien wie Polypropylen sind jedoch ebenfalls geeignet. Als Schichtträger für Schichtdicken unter ca. 10 µm werden meist Metalle verwendet. Für Offsetdruckplatten können eingesetzt werden: mechanisch oder chemisch aufgerauhtes und gegebenenfalls anodisiertes Aluminium, das zudem noch chemisch, z. B. mit Polyvinylphosphonsäure, Silikaten oder Phosphaten, vorbehandelt sein kann.

Schließlich kann die Beschichtung direkt oder durch Schichtübertragung vom temporären Schichtträger erfolgen auf Leiterplatten-Materialien, die aus Isolierplatten mit ein- oder beidseitiger Kupferauflage bestehen, auf Glas oder Keramik-Materialien, die gegebenenfalls haftvermittelnd vorbehandelt sind, und auf Silicium-Scheiben. Außerdem können Holz, Textilien und Oberflächen vieler Werkstoffe beschichtet werden, die vorteilhaft durch Projektion bebildert werden und resistent gegen die Einwirkung alkalischer Entwickler sind.

Für die Trocknung nach der Beschichtung können die üblichen Geräte und Bedingungen übernommen werden, Temperaturen um 100 °C und kurzfristig bis 120 °C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Bestrahlung ist in dieser Beschreibung die Einwirkung aktinischer elektromagnetischer Strahlung im Wellenlängenbereich unterhalb etwa 500 nm zu verstehen. Alle in diesem Wellenlängenbereich emittierenden Strahlungsquellen sind prinzipiell geeignet.

Mit Vorteil werden Laserbestrahlungsgeräte, insbesondere automatische Verarbeitungsanlagen verwendet, die als Strahlungsquelle einen Argon-Ionen-Laser enthalten.

Die Bestrahlung kann auch mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z. B. halogenierte aromatische Verbindungen oder halogenierte polymere Kohlenwasserstoffe. Röntgen- oder Ionenstrahlen können ebenfalls zur Bilderzeugung verwendet werden.

Die bildmäßig belichtete oder bestrahlte Schicht kann in bekannter Weise mit den für handelsübliche Naphthochinondiazid-Schichten und Kopierlacke bekannten Entwicklern entfernt werden, und die neuen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können z. B. Alkaliphosphate,-silikate oder -hydroxide und ferner Netzmittel sowie ggf. kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Bei der Anwendung als Druckplatten können zur Erhöhung der Widerstandsfähigkeit beim Druck sowie der Resistenz gegen Auswaschmittel, Korrekturmittel und durch UV-Licht härtbare Druckfarben die entwickelten Platten kurze Zeit auf erhöhte Temperaturen erwärmt werden, wie es für Diazoschichten aus der GB-A 1 154 749 bekannt ist.

Erfindungsgemäß wird auch ein Verfahren zur Herstellung von Reliefbildern vorgeschlagen, bei dem man ein strahlungsempfindliches Aufzeichnungsmaterial aus einem Schichtträger und einer Aufzeichnungsschicht, die aus dem eingangs definierten strahlungsempfindlichen Gemisch besteht, bildmäßig mit aktinischer Strahlung in solcher Dosis bestrahlt, daß die Löslichkeit der Schicht in einer wäßrig-alkalischen Entwicklerlösung zunimmt, und die bestrahlten Schichtteile mittels einer wäßrig-alkalischen Entwicklerlösung entfernt. Das Verfahren ist dadurch gekennzeichnet, daß die Aufzeichnungsschicht als Bindemittel ein Polymerisat mit Einheiten der allgemeinen Formel I enthält.

Durch die Erfindung sind Positivschichten zugänglich, deren Eigenschaften sich je nach den anwendungstechnischen Erfordernissen gezielt einstellen lassen. Durch die geeignete Wahl der erfindungsgemäßen Bindemittel lassen sich z. B. Positivschichten für die Anwendung in dünner Schicht erhalten, die eine ausgezeichnete Haftung zum Substrat sowie eine hervorragende Temperatur-, Ätz- und Abriebbeständigkeit aufweisen.

Andererseits lassen sich mit den hier vorgeschlagenen Bindemitteln auch Positivschichten für Anwendungen in größeren Schichtdicken von etwa 15 µm bis 100 µm und darüber, z. B. als Trockenresist, erhalten. Diese trockenen Filme weisen eine hohe Lichtempfindlichkeit und eine ausgezeichnete Flexibilität auf und lassen sich einwandfrei von der Rolle verarbeiten. Sie haften nach der trockenen Übertragung gut auf metallischen Trägern und zeigen auch bei größeren Schichtdicken keine Risse oder Brüche in der Schicht. Vor allem beim Schneiden treten keine Absplitterungen von Schichtteilen auf.

Die folgenden Beispiele zeigen Möglichkeiten für die Durchführung des erfindungsgemäßen Verfahrens bzw. für die Herstellung und Anwendung der Bindemittel in den erfindungsgemäßen Gemischen.

Prozent- und Gewichtsangaben sind, wenn nicht anders angegeben, in Gewichtseinheiten zu verstehen. Gewichtsteile (Gt) und Volumteile (Vt) stehen im Verhältnis von g zu ml.

Für verschiedene Anwendungsmöglichkeiten werden die folgenden Beschichtungslösungen hergestellt:

Beschichtungslösung A:

| | | |
|---|---|---|
| 40 | Gt | Bindemittel, |
| 10 | " | des Polyacetals aus Triethylenglykol und Butyraldehyd, |
| 0,5 | Gt | 2-(4-Ethoxy-naphth-1-yl)-4,6-bis-trichlormethyl-s-triazin und |
| 0,05 | " | Kristallviolettbase in |
| 110 | " | Butanon |

Beschichtungslösung B:

| | | |
|---|---|---|
| 40 | Gt | Bindemittel, |
| 8 | " | eines polymeren Orthoesters, hergestellt durch Kondensation von Orthoameisensäuretrimethylester mit 4-Oxa-6,6-bis-hydroxymethyl-octan-1-ol, |
| 0,5 | " | 2-(4-Styrylphenyl)-4,6-bis-trichlormethyl-s-triazin und |
| 0,05 | " | Kristallviolettbase in |
| 80 | " | Butanon und |
| 20 | " | Ethanol |

Beschichtungslösung C:

| | | |
|---|---|---|
| 10 | Gt | Bindemittel, |
| 3 | " | des Bis-(5-butyl-5-ethyl-1,3-dioxan-2-yl)-ethers des 2-Butyl-2-ethylpropandiols und |
| 0,25 | " | 2-(Acenaphth-5-yl)-4,6-bis-trichlormethyl-s-triazin in |
| 90 | " | Butanon |

Beschichtungslösung D:

| | | |
|---|---|---|
| 20 | Gt | Bindemittel, |
| 6,5 | " | eines Kresol-Formaldehyd-Novolaks mit einem Erweichungsbereich von 105-120 °C, |
| 3,5 | " | des Polyacetals aus Beschichtungslösung A und |
| 0,5 | " | 2-(4-Ethoxy-naphth-1-yl)-4,6-bis-trichlor-methyl-s-triazin in |
| 70 | " | eines Lösungsmittelgemischs aus 1-Methoxy-propanol-2, Butylacetat und Xylol (8:1:1) |

Beschichtungslösung E:

| | | |
|---|---|---|
| 8 | Gt | Bindemittel, |
| 1 | " | des Polyacetals aus Beschichtungslösung A, |
| 0,5 | " | 2-(4-Styrylphenyl)-4,6-bis-trichlor-methyl-s-triazin und |
| 0,05 | " | Kristallviolettbase in |
| 80 | " | 1-Methoxy-propanol-2 und |
| 20 | " | Butylacetat |

Beispiele 1 bis 4:

Zur Herstellung von Offsetdruckplatten werden die folgenden Bindemittel entsprechend den Angaben der Beschichtungslösung E mit den dort angegebenen Komponenten gemischt:

a) Copolymeres aus Brenzcatechinmonomethacrylat und Methylmethacrylat (90:10 mol-%, RSV-Wert: 0,438 dl/g in Dimethylformamid),
b) Copolymeres aus Hydrochinonmonomethacrylat und Butylmethacrylat (70:30 mol-%, RSV-Wert: 0,365 dl/g in Dimethylformamid),
c) Copolymeres aus Methylmethacrylat und dem Umsetzungsprodukt von Hydroxyethylmethacrylat und Salicylsäure (80:20 mol-%, RSV-Wert: 0,511 dl/g in Dimethylformamid) und
d) Copolymeres aus p-Hydroxyphenylmethacrylamid und Hexylmethacrylat (55:45 mol-%, RSV-Wert: 0,443 dl/g in Dimethylformamid).

Vergleichsbeispiel V 1:

Zum Vergleich wird das Copolymere b) in folgender Rezeptur angesetzt:

| | | |
|---|---|---|
| 8 | Gt | Copolymeres b), |
| 1 | " | des Veresterungsprodukts aus 1 mol 2,3,4-Trihydroxybenzophenon und 3 mol Naphthochinon(1,2)-diazid-(2)-5-sulfonsäurechlorid und |
| 0,01 | " | Kristallviolettbase in |
| 80 | " | 1-Methoxy-propanol-2 und |
| 20 | " | Butylacetat |

Diese Lösungen werden auf elektrolytisch aufgerauhte und anodisierte Aluminiumplatten, die zuvor mit einer wäßrigen Lösung von Polyvinylphosphonsäure behandelt worden sind, aufgeschleudert. Durch Einstellung der Umdrehungszahl der Schleuder wird die Schichtdicke (trocken) bei allen Platten auf ca. 1,5 µm gebracht.

Anschließend werden die Platten 10 Minuten bei 100 °C im Umluftschrank getrocknet.

Nach Belichten unter einer 5 kW-Metallhalogenidlampe in 110 cm Abstand und nach einer Wartezeit von 10 Minuten werden die Platten in einer Lösung aus

| | | |
|---|---|---|
| 5,3 | Gt | Natriummetasilikat x 9 $H_2O$, |
| 3,4 | " | Trinatriumphosphat x 12 $H_2O$ und |
| 0,3 | " | Natriumdihydrogenphosphat (wasserfrei) in |
| 91,0 | " | Wasser |

entwickelt, wobei die vom Licht getroffenen Anteile der Kopierschicht entfernt werden, so daß die unbelichteten Bildstellen auf der Platte zurückbleiben.

In Tabelle 1 sind die als Bindemittel eingesetzten Copolymeren sowie die Belichtungs- und Entwicklungszeiten für die einzelnen Schichten zusammengestellt.

Tabelle 1

| Beispiel | Copolymeres | Belichtungszeit (s) | Entwicklungszeit (s) |
|---|---|---|---|
| 1 | a | 30 | 80 |
| 2 | b | 10 | 30 |
| 3 | c | 40 | 60 |
| 4 | d | 10 | 70 |
| V 1 | b | 100 | 90 |

Die Tabelle 1 zeigt sehr deutlich die Vorteile der neuen Gemische hinsichtlich Lichtempfindlichkeit. In allen geprüften Fällen liegt diese etwa um den Faktor 2 bis 5 höher als bei konventionellen Gemischen mit Naphthochinondiaziden.

Von den so hergestellten Druckformen konnten nach Einfärbung mit oleophiler Druckfarbe in einer Offsetdruckmaschine 100.000 einwandfreie Drucke hergestellt werden.

Beispiele 5 bis 8

Zur Herstellung eines Positiv-Trockenresists werden entsprechend den Angaben der Beschichtungslösungen A und B die folgenden Bindemittel mit den übrigen Komponenten gemischt (siehe Tabelle 2).

e) Copolymeres aus Resorcinmonomethacrylat und 2-Ethylhexylmethacrylat (68:32 mol-%), RSV-Wert: 0,589 dl/g in Dimethylformamid),

f) Copolymeres aus Hydrochinonmonoacrylat und Butylmethacrylat (65:35 mol-%, RSV-Wert: 0,323 dl/g in Dimethylformamid),

g) Copolymeres aus Hydrochinonmonomethacrylat, Hexylmethacrylat und Butylacrylat (65:25:10 mol-%, RSV-Wert: 0,554 dl/g in Dimethylformamid),

h) Copolymeres aus m-Hydroxyphenylmethacrylamid, Hexylmethacrylat und 1,1,2,2-Tetrahydroperfluordecylacrylat (55:40:5 mol-%, RSV-Wert: 0,448 dl/g in Dimethylformamid)

Vergleichsbeispiel V 2

Zum Vergleich wird das Copolymere g) in folgender Rezeptur angesetzt:

| | | |
|---|---|---|
| 40 | Gt | Copolymeres g), |
| 8 | " | des Veresterungsprodukts aus 1 mol 2,3,4-Trihydroxybenzophenon und 3 mol Naphthochinon-(1,2)-diazid-(2)-5-sulfonsäurechlorid und |
| 0,05 | " | Kristallviolettbase in |
| 80 | " | Butanon und |
| 20 | " | Ethanol |

Die Lösungen der Beispiele 5 bis 8 und des Vergleichsbeispiels V 2 werden jeweils auf 26 µm dicke, biaxial verstreckte und thermofixierte Polyethylenterephthalatfolien aufgeschleudert und anschließend 10 Minuten bei 100 °C im Umlufttrockenschrank nachgetrocknet. Die Umdrehungszahl der Schleuder wird so reguliert, daß eine Schichtdicke von ca. 25 µm erhalten wird. Zum Schutz gegen Staub und Verkratzungen wird darauf noch eine Polyethylenfolie kaschiert.

Die Trockenresists mit den erfindungsgemäßen Gemischen weisen eine gegenüber dem Trockenresist mit Naphthochinondiazid deutlich verbesserte Flexibilität auf. Während der letztere beim Schneiden leicht springt oder Risse zeigt, treten diese Nachteile bei den erfindungsgemäßen Trockenresists nicht auf.

Zur Herstellung von Leiterplatten werden die Trockenresists nach Abziehen der Deckfolie in einem handelsüblichen Laminator auf einen gereinigten, vorgewärmten Träger, der aus einer Isolierstoffplatte mit 35 µm dicker Kupferauflage besteht, laminiert. Nach Abziehen der Trägerfolie und eventuellem Nachtrocknen wird unter einer Vorlage mit einer 5 kW-Metallhalogenidlampe in 110 cm Abstand belichtet und nach einer Wartezeit von 10 Minuten in dem in den Beispielen 1 bis 4 angegebenen Entwickler entwickelt. Tabelle 2 zeigt die benötigten Belichtungs- und Entwicklungszeiten.

Tabelle 2

| Beispiel Nr. | Copolymeres | Beschichtungslösung | Belichtungszeit (s) | Entwicklungszeit (s) |
|---|---|---|---|---|
| 5 | e | B | 10 | 70 |
| 6 | f | A | 10 | 50 |
| 7 | g | A | 10 | 80 |
| 8 | h | B | 15 | 70 |
| V 2 | g | - | 100 | 80 |

Auch diese Beispiele zeigen die erhöhte Lichtempfindlichkeit der neuen Gemische im Vergleich mit Naphthochinondiazidschichten.

Die auf diese Weise entstandenen Resistschablonen weisen eine hervorragende Galvanoresistenz auf, insbesondere bei dem galvanischen Aufbau von Kupfer und Pb/Sn-Legierungen.

Derartig behandelte Platten lassen sich anschließend erneut belichten und entwickeln. Mit dieser Arbeitsweise lassen sich in einem ersten Schritt Lötaugen aus Pb/Sn an den Bohrlöchern galvanisieren, in einem zweiten Belichtungs- und Entwicklungsschritt läßt sich dann das Leiterbahnbild auf die noch lichtempfindliche Resistschablone übertragen. Nach dem Ätzen des freigelegten Kupfers mit ammoniakalischer Cu(II)-chlorid-Lösung erhält man eine Leiterplatte in Kupfertechnik, d. h. die Pb/Sn-Legierung wird nur dort aufgebaut, wo sie beim nachfolgenden Lötprozeß benötigt wird.

Beispiele 9 bis 13

Zur Herstellung mikroelektronischer Schaltelemente hoher Integration werden nach Angaben der Beschichtungslösungen C und D die folgenden Bindemittel mit den dort angegebenen Komponenten gemischt (siehe Tabelle 3):

h) Copolymeres aus 3-Hydroxynaphth-2-yl-methacrylat und Styrol (86:14 mol-%, RSV-Wert: 0,213 dl/g in Dimethylformamid),

i) Copolymeres aus 2-Hydroxy-3-(2-hydroxy-3-naphthoyloxy)propylmethacrylat und Styrol (60:40 mol-%, RSV-Wert: 0,383 dl/g in Dimethylformamid),

k) Homopolymeres aus Brenzcatechinmonomethacrylat (RSV-Wert: 0,460 dl/g in Dimethylformamid),

l) Homopolymeres aus dem Umsetzungsprodukt von 2-Hydroxyethylmethacrylat und 3-Methylsalicylsäure (RSV-Wert: 0,339 dl/g in Dimethylformamid),

m) Copolymeres aus Hydrochinonmonomethacrylat und Biphenyl-4-methacrylat (90:10 mol-%, RSV-Wert: 0,476 dl/g in Dimethylformamid).

Tabelle 3

| Beispiel | Polymeres | Beschichtungslösung |
|---|---|---|
| 9 | h | C |
| 10 | i | D |
| 11 | k | C |
| 12 | l | D |
| 13 | m | C |

Nach Filtration durch ein Filter mit Porendurchmesser von 0,2 µm (Millipore) werden die Photoresistlösungen auf käufliche, wie üblich polierte und durch Oxidation mit einer 0,2 µm dicken $SiO_2$-Schicht versehene Siliciumscheiben geschleudert. Durch Variation der Umdrehungszahl werden die Schichtdicken auf ca. 0,9 µm bis 1,2 µm eingestellt.

Die so beschichteten Scheiben werden 30 Minuten bei 90 °C getrocknet. Nach dem Abkühlen und Konditionieren auf ein definiertes Raumklima von 23 °C und 40 - 50 % relativer Feuchte werden die Wafer in einem Kontaktbelichtungsgerät unter einer handelsüblichen Chrommaske etwa 1 Sekunde belichtet.

Entwickelt wird bei 25 °C in einem bewegten Entwickler, bestehend aus
2,67 % Natriummetasilikat × 9 $H_2O$,
1,71 % Trinatriumphosphat × 12 $H_2O$,
0,17 % Natriumdihydrogenphosphat
(wasserfrei),
gelöst in 95,45 % vollentsalztem Wasser.

Durch die guten filmbildenden Eigenschaften der Bindemittel wird die Haftung und damit die Ätzresistenz bei der Ätzung mit durch $NH_4F$ gepufferter Fluorwasserstoffsäure merklich verbessert.

Die Auflösung der mit den erfindungsgemäß genannten Gemischen strukturierten Muster liegt bei 1 bis 2 µm.

Beispiele 14 und 15

Platten aus elektrolytisch aufgerauhtem, anodisiertem und mit Polyvinylphosphonsäure vorbehandeltem Aluminium werden mit 2,5 µm dicken Schichten entsprechend Beschichtungslösung A beschichtet. Als Bindemittel werden jeweils verwendet:

n) Copolymeres aus Resorcinmonomethacrylat und 2-Ethylhexylmethacrylat (68:32 mol-%, RSV-Wert: 0,478 dl/g in Dimethylformamid),
o) Copolymeres aus Hydrochinonmonomethacrylat und Hexylmethacrylat (72:28 mol-%, RSV-Wert: 0,461 dl/g in Dimethylformamid).

Diese Schichten werden in einem handelsüblichen Laserbestrahlungsgerät mit einem Argonionenlaser mit 10 mJ/cm² bildmäßig bestrahlt. Die bestrahlten Schichtteile werden anschließend innerhalb 90 Sekunden mit dem Entwickler der Beispiele 1 bis 4 entfernt.

Nach Einfärben der unbestrahlten Bereiche mit oleophiler Farbe erhält man eine Druckform mit besserer Beschichtungsqualität und Farbannahme im Vergleich zu Naphthochinondiazidschichten.

**Patentansprüche**

1. Strahlungsempfindliches Gemisch, das als wesentliche Bestandteile
A) ein in Wasser unlösliches, in wäßrig-alkalischen Lösungen lösliches polymeres Bindemittel mit seitenständigen phenolischen Hydroxygruppen und
B) eine Kombination aus
a) einer unter Einwirkung von aktinischer Strahlung eine starke Säure bildenden Verbindung und
b) einer Verbindung mit mindestens einer durch Säure spaltbaren C-O-C-Bindung enthält, deren Löslichkeit in einem flüssigen Entwickler durch Einwirkung von Säure erhöht wird,
dadurch gekennzeichnet, daß das Bindemittel ein Polymeres mit wiederkehrenden Einheiten der allgemeinen Formel I

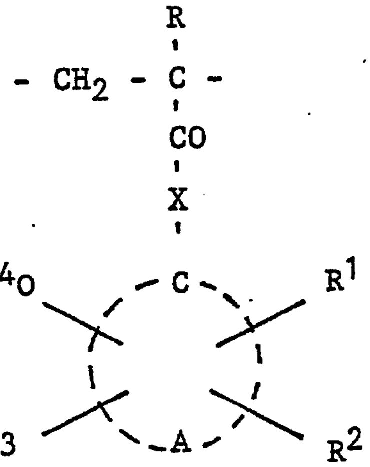

(I)

ist, worin
R ein Wasserstoff- oder Halogenatom, eine Cyanidgruppe oder eine Alkylgruppe mit 1–4 Kohlenstoffatomen ist,
$R^1$, $R^2$ und $R^3$ gleich oder verschieden sind und Wasserstoff- oder Halogenatome, Alkyl-, Alkoxy-, Alkoxycarbonyl-, Acyl-, Aryloxy-, Aroyl- oder Aralkylgruppen bedeuten,
$R^4$ ein Wasserstoffatom oder eine zweiwertige organische Gruppe ist, die mit einer weiteren Einheit der Formel I inter- oder intramolekular verknüpft ist, wobei im Mittel in mindestens 80 mol-% der Einheiten der Formel I $R^4$ ein Wasserstoffatom ist,
eine der Gruppen $NR^8$, $OCH_2CHOHCH_2OCO$, $OCH_2CH_2O$ und $OCH_2CH_2OCO$ ist, worin $R^8$ eine Arylgruppe bedeutet, und
A die zur Vervollständigung eines ein- oder zweikernigen carbo- oder heterocyclischen aromatischen Ringsystems erforderlichen Atome bedeutet.

2. Strahlungsempfindliches Gemisch nach Anspruch 1, dadurch gekennzeichnet, daß das Bindemittel zusätzlich Einheiten der allgemeinen Formel II

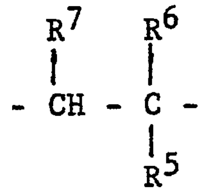

(II)

enthält, worin
$R^5$ ein Wasserstoff- oder Halogenatom oder eine Alkylgruppe,
$R^6$ eine Alkyl-, Alkoxy-, Alkoxycarbonyl-, Acyl-, Acyloxy-, Aryl-, Formyl-, Cyanid-, Carboxyl-, Hydroxy- oder Aminocarbonylgruppe und
$R^7$ ein Wasserstoffatom oder eine Carboxylgruppe bedeutet, die mit $R^6$, wenn dieses eine Carboxylgruppe ist, zu einem Säureanhydrid verbunden sein kann.

3. Strahlungsempfindliches Gemisch nach Anspruch 1, dadurch gekennzeichnet, daß A die zur Vervollständigung eines Benzolrings erforderlichen Kohlenstoffatome bedeutet.

4. Strahlungsempfindliches Gemisch nach Anspruch 1, dadurch gekennzeichnet, daß das Bindemittel ein Molekulargewicht $\overline{M}_n$ von 1000 bis 200.000 hat.

5. Strahlungsempfindliches Gemisch nach Anspruch 1, dadurch gekennzeichnet, daß das Bindemittel 20 bis 100 mol-% Einheiten der Formel I enthält.

6. Strahlungsempfindliches Aufzeichnungsmaterial mit einem Schichtträger und einer strahlungsempfindlichen Aufzeichnungsschicht, die als wesentlichen Bestandteil das strahlungsempfindliche Gemisch gemäß Anspruch 1 enthält.

7. Verfahren zur Herstellung von Reliefbildern, dadurch gekennzeichnet, daß man ein strahlungsempfindliches Aufzeichnungsmaterial gemäß Anspruch 6 bildmäßig mit aktinischer Strahlung in solcher Dosis bestrahlt, daß die Löslichkeit der Aufzeichnungsschicht in einer wäßrig-alkalischen Entwicklerlösung zunimmt, und die bestrahlten Schichtteile mittels einer wäßrig-alkalischen Entwicklerlösung auswäscht.

## Claims

1. A radiation-sensitive mixture which contains as essential constituents
A) a water-insoluble polymeric binder which is soluble in aqueous alkaline solutions and has phenolic hydroxyl side groups and
B) a combination of
a) a compound which forms a strong acid under the action of actinic radiation and
b) a compound which has at least one acid-cleavable C–O–C bond and the solubility of which in a liquid developer is increased by the action of acid,
wherein the binder is a polymer of repeat units of the formula I

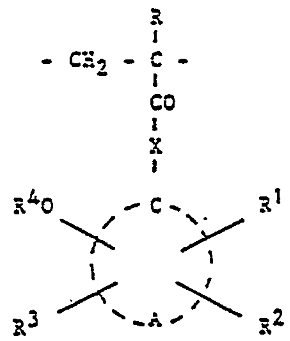

(I)

in which
R is a hydrogen or halogen atom, a cyanide group or an alkyl group of 1–4 carbon atoms,
$R^1$, $R^2$ and $R^3$ are identical or different and denote hydrogen or halogen atoms, alkyl, alkoxy, alkoxycarbonyl, acyl, aryloxy, aroyl or aralkyl groups,
$R^4$ is a hydrogen atom or a divalent organic group which is intermolecularly or intramolecularly linked to a further unit of formula I, on average in at least 80 mol-% of units of the formula I $R^4$ being a hydrogen atom,
X denotes one of the groups $NR^8$, $OCH_2CHOHCH_2OCO$, $OCH_2CH_2O$ and $OCH_2CH_2OCO$, in which $R^8$ denotes an aryl group and
A denotes the atoms required for completing a mononuclear or dinuclear carbocyclic or heterocyclic aromatic ring system.

2. The radiation-sensitive mixture as claimed in claim 1, wherein the binder additionally contains units of the formula II

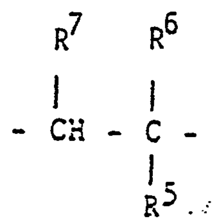

(II)

in which
$R^5$ is a hydrogen or halogen atom or an alkyl group,
$R^6$ is an alkyl, alkoxy, alkoxycarbonyl, acyl, acyloxy, aryl, formyl, cyanide, carboxyl, hydroxyl or aminocarbonyl group and
$R^7$ is a hydrogen atom or a carboxyl group which can be bonded to $R^6$, when the latter is a carboxyl group, to form an acid anhydride.

3. The radiation-sensitive mixture as claimed in claim 1, wherein A denotes the carbon atoms required for completing a benzene ring.

4. The radiation-sensitive mixture as claimed in claim 1, wherein the binder has a molecular weight $\overline{M}_n$ of 1000 to 200,000.

5. The radiation-sensitive mixture as claimed in claim 1, wherein the binder contains 20 to 100 mol-% of units of the formula I.

6. A radiation-sensitive recording material comprised of layer support and a radiation-sensitive recording layer which contains, as the essential constituent, the radiation-sensitive mixture as claimed in claim 1.

7. A process for preparing relief images, wherein a radiation-sensitive recording material as claimed in claim 6 is imagewise irradiated with actinic radiation in such an amount that the solubility of the recording layer in an aqueous alkaline developer solution increases, and the irradiated parts of the layer are washed out by means of an aqueous alkaline developer solution.

**Revendications**

1. Composition sensible aux radiations, contenant en tant que composants essentiels

A) un liant polymère à groupes hydroxy phénoliques latéraux, insoluble dans des solutions aqueuses alcalines, et

B) 1) une combinaison de

a) un composé formant un acide fort sous l'effet d'un rayonnement actinique et

b) un composé comportant au moins une liaison C–O–C pouvant être rompue par un acide, dont la solubilité dans un révélateur liquide est accrue sous l'effet d'un acide,

caractérisée en ce que le liant est un polymère comportant des motifs répétitifs de formule générale I

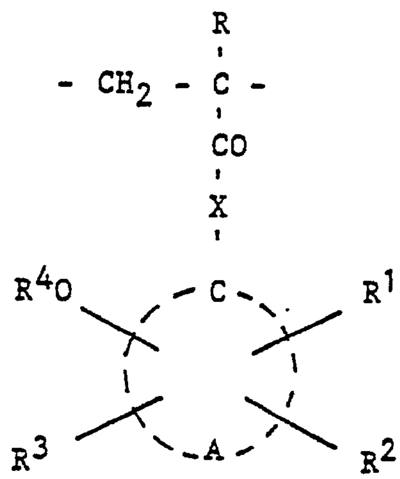

(I)

dans laquelle

R est un atome d'hydrogène ou d'halogène, le groupe cyano ou un groupe alkyle ayant de 1 à 4 atomes de carbone,

$R^1$, $R^2$ et $R^3$ sont identiques ou différents, et représentent des atomes d'hydrogène ou d'halogène, des groupes alkyle, alkoxy, alcoxycarbonyle, acyle, aryloxy, aroyle ou aralkyle,

$R^4$ est un atome d'hydrogène ou un groupe organique bivalent qui est lié par liaison inter- ou intramoléculaire à un autre motif de formule I, $R^4$ étant un atome d'hydrogène en moyenne dans au moins 80% en mole des motifs de formule 1,

X représente l'un des groupes $NR^8$, $OCH_2CHOHCH_2OCO$, $OCH_2CH_2O$ et $OCH_2CH_2OCO$, $R^8$ représentant un groupe aryle, et

A représente le atomes requis pour le complément d'un système cyclique aromatique carbocyclique ou hétérocyclique mono- ou binucléaire.

2. Composition sensible aux radiations selon la revendication 1, caractérisée ence que le liant contient en outre des motifs de formule générale II

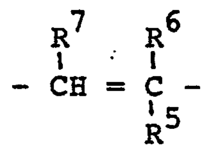

(II)

dans laquelle

$R^5$ est un atome d'hydrogène ou d'halogène ou un groupe alkyle,

$R^6$ est un groupe alkyle, alcoxy, alcoxycarbonyle, acyle, acyloxy, aryle, formyle, cyano, carboxy, hydroxy ou aminocarbonyle, et

$R^7$ est un atome d'hydrogène ou un groupe carboxy qui peut être lié à $R^6$, lorsque celui-ci est un groupe carboxy, pour former un anhydride d'acide.

3. Composition sensible aux radiations selon la revendication 1, caractérisée en ce que A représente les atomes de carbone requis pour le complément d'un cycle benzénique.

4. Composition sensible aux radiations selon la revendication 1, caractérisée en ce que le liant a une masse moléculaire $\overline{M}_n$ de 1000 à 200 000.

5. Composition sensible aux radiations selon la revendication 1, caractérisée en ce que le liant contient de 20 à 100% en mole de motifs de formule I.

6. Matériau de reprographie sensible aux radiations, comportant un support de couche et une couche de reproduction, sensible aux radiations, qui contient en tant que composant essentiel la composition sensible aux radiations selon la revendication 1.

7. Procédé pour la production d'images en relief, caractérisé en ce que l'on expose selon l'image un matériau de reprographie sensible aux radiations, selon la revendication 6, avec un rayonnement actinique en une dose telle que la solubilité de la couche de reproduction dans une solution aqueuse alcaline de développement augmente, et on élimine les parties irradiées de la couche par lavage à l'aide d'une solution aqueuse alcaline de développement.